# EUROPEAN PATENT APPLICATION

(11) **EP 1 796 132 A2**
(43) Date of publication of application: **13.06.2007**
(21) Application number: 06022435.9
(22) Date of filing: 26.10.2006
(51) Int. Cl.: H01J 37/20

(54) **Closed observational device for electron microscope**

(30) Priority: 09.12.2005 CN 200510130413
(71) Applicant: Lee, Bing-Huan, Kaohsiung County 833, Taiwan, R.O.C. (TW)
(72) Inventor: Chao, Chih-Yu, Da-An District Taipei City 106 Taiwan (CN); Hsieh, Wen-Jiunn, Jhonghe City Taipei County 235 Taiwan (CN)
(74) Representative: Becker Kurig Straus

(57) **Abstract**

A closed observational device (10) for an electron microscope is formed of a housing (11). The housing (11) includes a liquid chamber (12) formed therein, at least one view hole (13) formed at each of a top side thereof and a bottom side thereof and communicating with the liquid chamber (12) and coaxially aligned with the other, and a film (131) mounted to and sealing each of the view holes (13). Accordingly, a general specimen or a live cell can be placed into the liquid chamber (12) for microscopic observation under the electron microscope. Besides, the present invention can enclose the liquid inside the housing (11) to prevent the liquid from exhausting outward or volatilization.

## Description

### BACKGROUND OF THE INVENTION

### 1. Field of the Invention

The present invention relates generally to electron microscopes, and more particularly, to a closed observational device for an electron microscope.

### 2. Description of the Related Art

As known in prior art, while a conventional electron microscope is operated to observe an object, the object has to be a nonvolatile solid for further microscopic observation because of the limitation of the vacuum environment of the specimen chamber inside the electron microscope. If the object is volatile, such as liquid, gas, or other fluid, the object will generate a great amount of gas upon after being put into the vacuum specimen chamber, and thus, not only the electron beam of the electron microscope will fail to penetrate the object for successful imaging or experiment of electron diffraction, but also high-vacuum area, like electron beam gun, will lower its vacuum level or cause contamination therein, further damaging the microscope.

Limited to the vacuum environment, the conventional electron microscope could be operated for structural observation of solid substance inside the specimen chamber or for observation of dehydrated biological tissues only, like cells, bacteria, or viruses, neither for observation of any cell, bacterium, virus or the like having physiological functions under the fluid environment, absolutely nor for observation of biochemical reaction processes, like transcription between deoxyribonucleic acid (DNA) and ribonucleic acid (RNA) inside the nucleus and translation between RNA and protein, microtubules inside the cytoplast, and of any vital biological phenomenon, like physiology of transduction at neuromuscular junctions.

Therefore, there must be a device that the live cell or tissue could be put therein and the device could be put into the specimen chamber of the electron microscope for observation.

Although some people proposed an environment inside the electron microscope for observation, such as Gai P. L. (Gai P. L., Microscopy & Microanalysis 8, 21, 2002). However, such design has the following drawbacks. It failed to keep the pressure of the specimen chamber close to the normal pressure or higher for observation and analysis, because the liquid under the liquid-gas equilibrium will instantly fully volatilize, thus requiring supplementary liquid for entry into the specimen chamber. However, such entry of supplementary liquid will cause serious problems of flow or uneven admixture of new and original specimens to result in inauthenticity of the observation. Moreover, the massive volatilized high-pressure vapor or the high-pressure gas injected into the gas chamber from outside will fill the space between the upper and lower pole pieces to cause more serious multiple electron scattering due to electrons impinging excessive gasiform molecules, further disabling successful imaging of the electron beam or experiment of electron diffraction. Furthermore, the specimen chamber in design fails to effectively control the amount of the injected liquid, causing excessive thickness of the liquid to further disable penetration of the electron beam through the specimen and thus disabling observation and analysis.

In view of above, after successive trials and experiments, the present invention is finally invented to improve the aforementioned drawbacks of the prior art and to receive general specimens or live cells for observation under the microscope.

### SUMMARY OF THE INVENTION

The primary objective of the present invention is to provide a closed observational device for an electron microscope; the closed observational device can be placed with a general specimen or live cell therein for observation under the microscope.

The secondary objective of the present invention is to provide a closed observational device for an electron microscope; none of any liquid exhausts outward or volatilizes to generate a great amount of gas while the liquid is injected into the closed observational device, therefore enabling easier and clearer observation.

The foregoing objectives of the present invention are attained by the closed observational device formed of a housing. The housing includes a liquid chamber and at least two view holes. The two view holes are formed at a top side and a bottom side of the housing, communication with the liquid chamber and coaxially aligned with each other. A film is mounted to and seals each of the view holes. Accordingly, a general specimen or a live cell can be placed into the liquid chamber for observation under the electron microscope. Besides, the present invention can enclose the liquid inside the housing to prevent the liquid from exhausting outward.

In a first preferred embodiment of the present invention, a liquid chamber is formed in a housing and two films seal a top side and a bottom side of the liquid chamber respectively.

In a second preferred embodiment of the present invention, a liquid chamber is formed in a housing, two gas chambers are formed above and below the liquid chamber respectively, and two films seal the two gas chambers respectively.

In a third preferred embodiment of the present invention, a liquid chamber is formed in a housing, two gas chambers are formed above and below the liquid chamber respectively, two buffer chambers are formed above and below the two gas chambers respectively, and two films seal the two buffer chambers respectively.

### BRIEF DESCRIPTION OF THE DRAWINGS

FIG 1 is a perspective view of a first preferred embodiment of the present invention.
FIG 2 is a sectional view of the first preferred embodiment of the present invention.
FIGS. 3(A), 3(B), 3(C), and 3(D) illustrate alternative formations of the film according to the first preferred embodiment of the present invention.
FIG 4 is a schematic view of the first preferred embodiment of the present invention in cooperation with the electron microscope for observation.
FIG 5 is another sectional view of the first preferred embodiment of the present invention, showing that the housing is formed of a cover shell and a base shell combined together.
FIG 6 is a sectional view of a second preferred embodiment of the present invention.
FIG 7 is a schematic view of the second preferred embodiment of the present invention in cooperation with the electron microscope for observation.
FIG 8 is a sectional view of a third preferred embodiment of the present invention.
FIG 9 is a schematic view of the third preferred embodiment of the present invention in cooperation with the electron microscope for observation.
FIG 10 is another sectional view of the third preferred embodiment of the present invention in cooperation with a specimen holder.

### DETAILED DESCRIPTION OF PREFERRED EMBODIMENTS

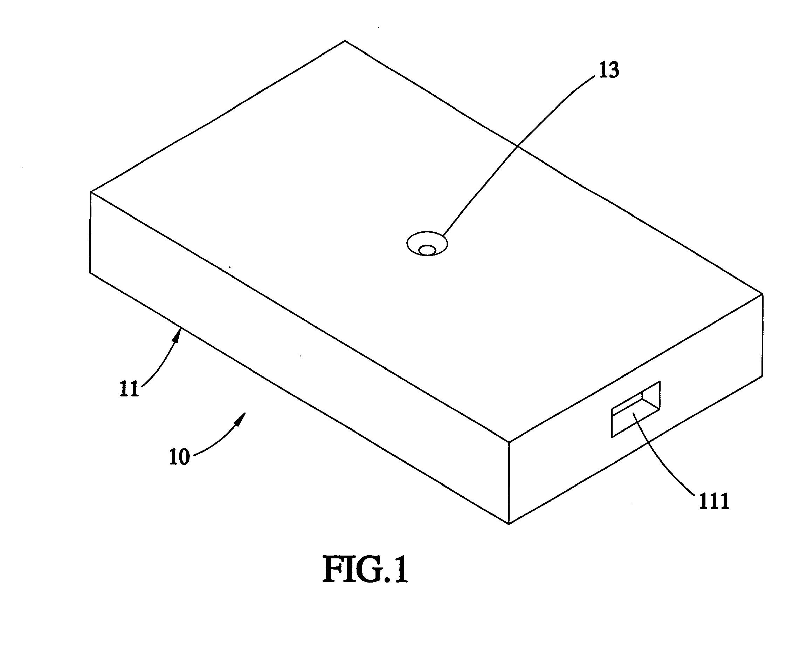

Referring to FIG 1-3(A), a closed observational device 10 for an electron microscope according to a first preferred embodiment of the present invention is formed of a housing 11.

The housing 11 is formed in one piece, including a liquid chamber 12 formed therein, and at least one view hole 13 formed at each of a top side thereof and a bottom side thereof. The two view holes 13 communicate with the liquid chamber 12 and are coaxially aligned with each other. A film 131 is mounted and seals each of the view holes 13 and can be an amorphous carbon film or a polymeric film having preferable resilience. Each of the films 131 is located at an end of the view hole 13 and close to the liquid chamber 12. The distance between the two films 131 is smaller than 10µm. In this embodiment, a plurality of strips 132 are mounted to outer end surfaces of each of the films 131 and intersected with one another for strengthening the films 131 and to enable the films 131 to stand at least one atmospheric pressure to avoid rupture. The housing 11, the films 131, and the strips 132 are made in one piece by conventional microlithography. Each of the view holes 13 has a diameter of 5-500µm, wherein 50µm is preferable. The housing further includes an inlet 111 and an outlet 112 formed at two sides respectively.

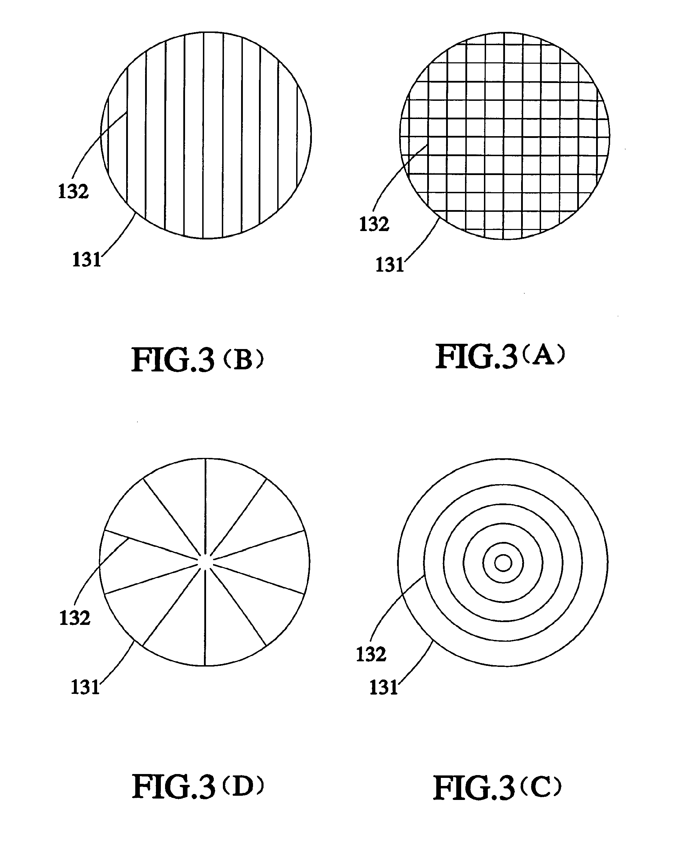

While a specimen 99 is placed into the closed observational device 10, the specimen 99 (e.g. a live cell and its nutrient fluid) are injected into the liquid chamber 12 through the inlet 111. The injected liquid can exhaust through the outlet 112 for pressure adjustment. Besides, by means of the outlet 112, the liquid and the specimen 99 can be drawn to control the amount of the liquid and the specimen 99 inside the liquid chamber 12. While the specimen 99 is a live cell, a nutrient fluid can be injected into the liquid chamber 12 and then the specimen 99 of the live cell can be fixed onto the film 131 or an internal sidewall of the liquid chamber 12 by a cell fastening agent, like poly-D-lysine, disposed on the film 131 or the internal sidewall of the liquid chamber 12. In this embodiment, in addition to intersectional arrangement, the strips 132 can be alternatively disposed on the films 131 in parallel or concentric circle or radius as shown in FIGS. 3(B)-3(D), and the films 131 and the strips 132 can be made by the conventional microlithography.

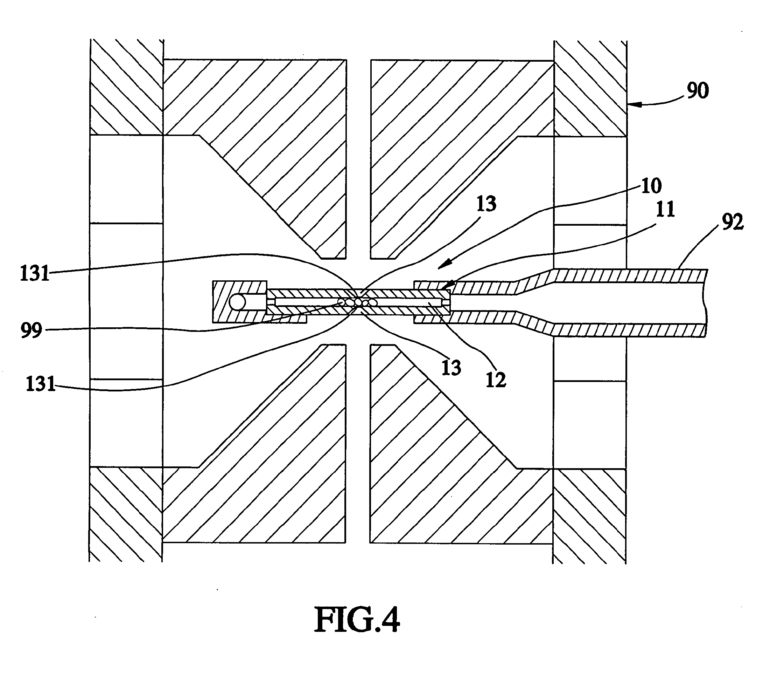

While the observation is in process, as shown in FIG 4, the closed observational device 10 in cooperation with a specimen holder 90 is put into the electron microscope 90 and the electron beam (not shown) of the electron microscope 90 passes through the two view holes 13 to observe the specimen 99 inside the liquid chamber 12 for imaging. Because the view holes 13 are sealed with the films 131, the liquid inside the liquid chamber 12 neither flows out of the view holes 13 nor exhausts nor volatilizes, and thus the vacuum environment inside the electron microscope avoids destruction. Accordingly, the live-cell specimen 99 or any other specimen can be observed under the electron microscope. In addition, the distance between the two films 131 is smaller than 10µm, such that the height of the liquid chamber 12 for observation is very low, i.e. the liquid inside the liquid chamber 12 is very thin, to allow penetration of the electron beam of the electron microscope for effective imaging.

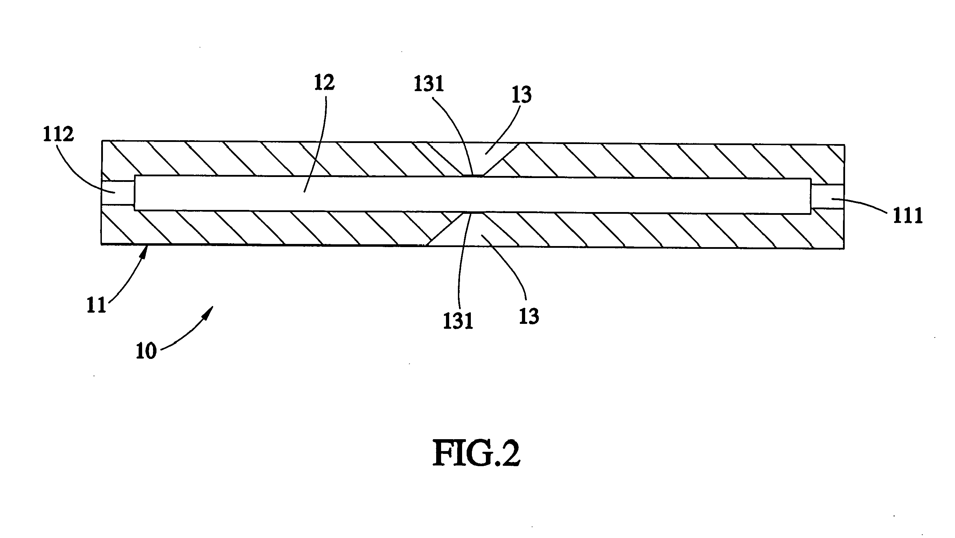

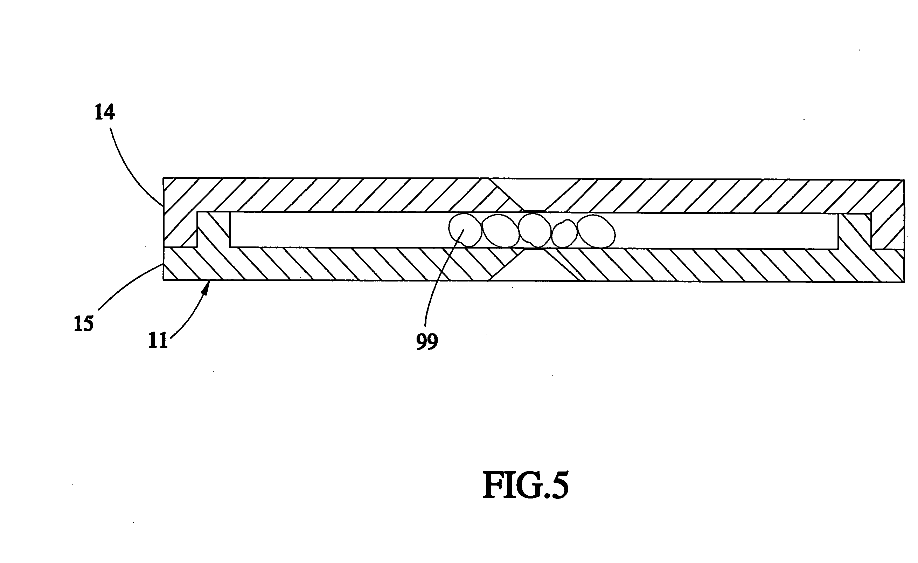

Further, in addition to the one-piece formation shown in FIG 2, the housing 11 can be alternatively formed of a cover shell 14 and a base shell 15, as shown in FIG 5. The housing 11 can be assembled by covering the base shell 15 with the cover shell 14 after the specimen 99 is put into the base shell 15 and then combining them together by means of an adhesive (not shown).

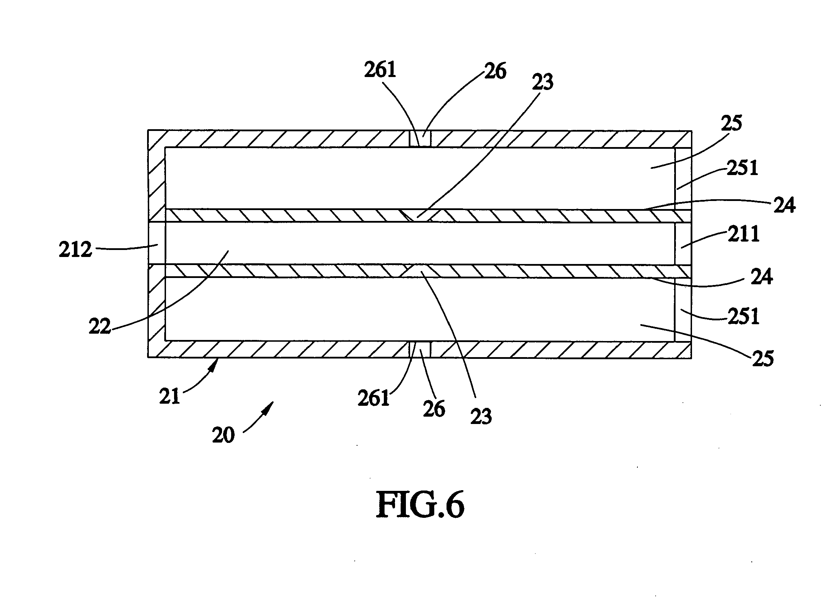

Referring to FIG 6, a closed observational device 20 for the electron microscope according to a second preferred embodiment of the present invention is formed of a housing 21.

The housing 21 includes at least one spacer 24 (two spacers 24 in this embodiment) formed therein for partitioning an internal space thereof into a liquid chamber 22 and two gas chambers 25 formed above and below the liquid chamber 22 respectively. At least one view hole 23 is formed on each of a top side of and a bottom side of the liquid chamber 22 and located at the spacers 24 for communication with the liquid chamber 22. The two gas chambers 25 cover the two view holes 23. At least one gas aperture 26 is formed at each of a top side of and a bottom side of the gas chamber 25 and coaxially aligned with the view holes 23. A film 261 is mounted and seals each of the gas apertures 26. The housing 21 further includes a pressure balance aperture 251 formed at one side of each of the gas chambers 25, an inlet 211 formed at one side of the liquid chamber 22, and an outlet 212 formed at the other side of the liquid chamber 22.

Each of the view holes 23 in the sectional view is taper-shaped to have a diameter decreasingly lessening toward the liquid chamber 22. Hydrophobic or super-hydrophobic treatment is applied to the surfaces of sidewalls of the view holes 23 and the outer surfaces of the spacers 24. For example, prepare a plurality of pillars of each having a diameter of hundreds of nanometers. Each pillar is attached with a hydrophobic self-assembly monomolecular layer at a surface thereof for enabling the contact angle of a water drop on the surface thereof to be larger than 150 degrees, thus being super-hydrophobic. Because the housing 21 can be made in one piece by the conventional microlithography, both of the liquid and gas chambers 22 and 25 can keep ultra-thin to reduce the multiple electron scattering resulted from the electron beam impinging too many gasiform molecules when passing through the gas chamber. While the specimen 99 is put into the closed observational device, the specimen 99 with the liquid can be injected through the inlet 211 of the housing 21 into the liquid chamber 22 and the redundant injected specimen can exhaust through the outlet 212. The liquid/specimen exhausting through the view holes 23 would be repelled by the super-hydrophobic surfaces of the spacers 24 and the sidewalls of the view holes 23 and flow out of the pressure balance aperture 251 while the housing 21 stands upright. In addition, to prevent the liquid/specimen from exhausting through the view holes 23, in operation, provide the gas chamber 25 with a specific gas of a predetermined pressure and control difference between the pressure of the specific gas and the pressure of the injected liquid in the liquid chamber 22 to be smaller than or equal to the critical pressure of the liquid solution inside the liquid chamber 22 (Keller S. et al., Journal of Food Protection 66, 1260, 2003), such that the injected nutritious liquid or the liquid/specimen circulates inside the liquid chamber 22 to avoid exhausting through the view holes 23. While observation is intended, the circulation of the liquid/specimen inside the liquid chamber 13 can be stopped at any time as required by the experiment.

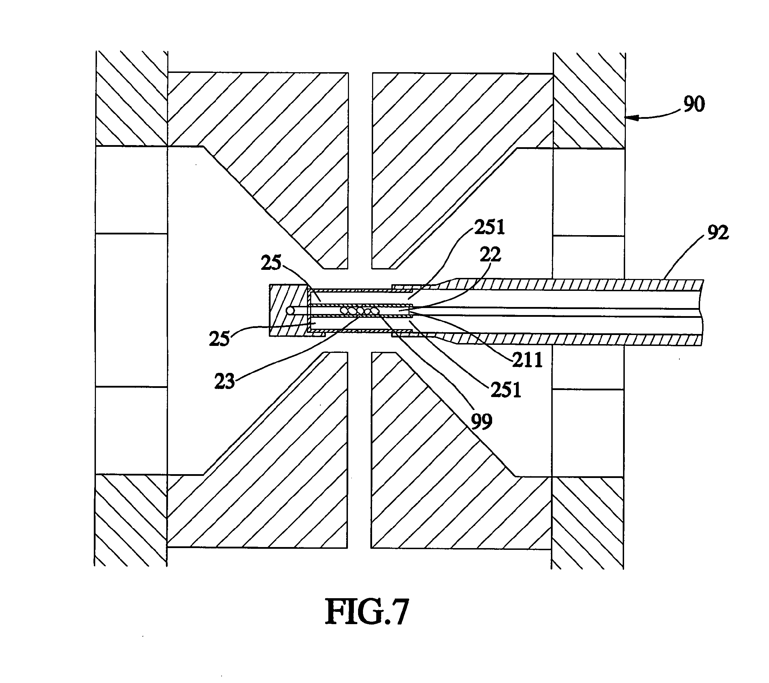

In the operation of the second embodiment, the closed observational device 20 cooperates with a specimen holder 92 and is put into the electron microscope. As the same as the first embodiment, referring to FIG 7, the liquid and the specimen 99 (e.g. the live cell) is injected through the inlet 211 into the liquid chamber 22 and vapor of predetermined pressure, e.g. an admixture of saturated/unsaturated water vapor and a specific gas, which can be nitrogen, oxygen, carbon dioxide, and an inert gas, in one atmospheric pressure totally, can be supplied through the pressure balance aperture 251 into the gas chamber 25, wherein the water vapor inside the gas chamber 25 can refrain the evaporation of the water inside the liquid chamber 22. Furthermore, it is alternative to supply the gas chamber 25 with a specific gas of one atmospheric pressure and to control difference between the pressure of the specific gas and the pressure of the water solution in the liquid chamber 22 to be smaller than or equal to the critical pressure that the water solution of the liquid chamber 22 exhausts from the liquid chamber 22, thus preventing the solution from flowing out of the view hole 23 from the liquid chamber 22 and enabling the liquid solution to merely volatilize slowly into the gas chamber 25. The pressure balance aperture 251 can balance the gas and the vapor inside the gas chamber 25.

In the second embodiment, the gas apertures 26 are mounted with the films 261, such that the vapor or the gas inside the gas chamber 25 does not exhaust through the gas apertures 26 out of the housing 21 to destruct the vacuum environment inside the electron microscope 90, thus attaining the potency of observing the live cell or other specimen 99.

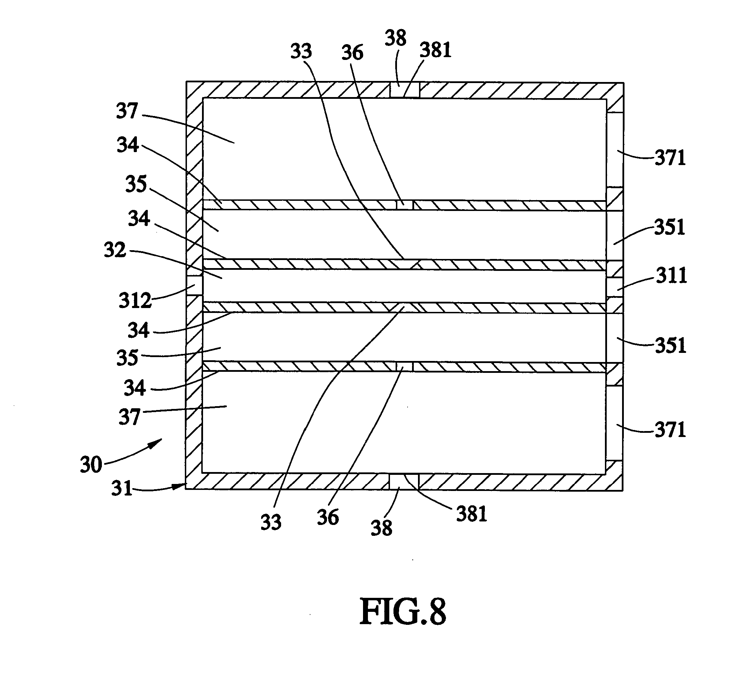

Referring to FIG 8, a closed observational device 30 for the electron microscope according to a third preferred embodiment of the present invention is formed of a housing 31.

The housing 31 includes at least two spacers 34, which are defined as four spacers 34 in this embodiment, for partitioning an inner space thereof into a liquid chamber 32, two gas chambers 35 formed above and below the liquid chamber 32 respectively and encapsulating the view holes 33, and two buffer chambers 37 formed above and below the two gas chambers 35 respectively. At least one view hole 33 is formed at each of a top side of and a bottom side of the liquid chamber 32 and located one of the spacers 34. Each of the view holes 33 communicates with the liquid chamber 32. Two gas apertures 36 are formed at a top side of the upper gas chamber 35 and a bottom side of the lower gas chamber 35 and located at two of the spacers 34 respectively. The two buffer chambers 37 encapsulating the two gas apertures36 respectively. The housing 31 includes an outer aperture 38 formed each of the top and bottom sides thereof and coaxially aligned with the gas apertures 36 and the view holes 33. A film 381 is mounted and seals each of the outer apertures 38 and located at an end of each of the outer apertures 38 and close to each of the buffer chambers 37. The housing 31 includes at least one gas inlet 351 formed at one side of each of the two gas chambers 35, a pumping port 371 formed at one side of each of the buffer chambers 37, an inlet 311 formed at one side of the liquid chamber 32, and an outlet 312 formed at the other side of the liquid chamber 32.

While the specimen 99 is put into the closed observational device 30, inject a liquid and the specimen 99 through the inlet 311 into the liquid chamber 32 and, in operation, supply a specific gas of predetermined pressure into the gas chambers 35 and keep the difference between the pressure of the specific gas and the pressure of the injected liquid being smaller than or equal to the critical pressure that the liquid solution exhausts out of the liquid chamber 32 to prevent the liquid/specimen from exhausting through the view holes 33. In the meantime, keep pumping out the two buffer chambers 37.

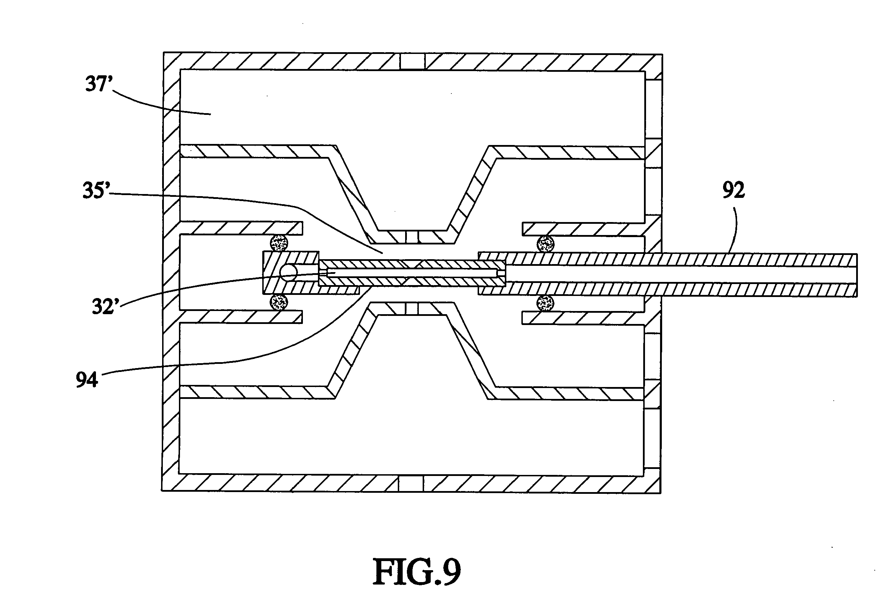

In the operation of the third embodiment, the status of the third embodiment of the present invention put into the electron microscope 90 is similar to that of the first embodiment. Referring to FIGS. 8 and 9, the liquid and the specimen 99 or the live cell are injected through the inlet 311 into the liquid chamber 32 and vapor of predetermined pressure, e.g. an admixture of saturated (or unsaturated) water vapor and a specific gas, which can be nitrogen, oxygen, carbon dioxide, and an inert gas, in one atmospheric pressure totally, can be supplied through the gas inlets 351 into the gas chambers 35, wherein the water vapor inside the gas chambers 35 can refrain the evaporation of the water inside the liquid chamber 32. Furthermore, it is alternative to supply the gas chambers 35 with a specific gas of one atmospheric pressure and to keep the difference between the pressure of the specific gas and the pressure of the water solution in the liquid chamber 32 to be smaller than or equal to the critical pressure that the water solution of the liquid chamber 32 exhausts out of the liquid chamber 32, thus preventing the water solution from flowing out of the view hole 33 and enabling the solution to merely volatilize slowly into the gas chamber 35; meanwhile, the gas and the vapor inside the gas chambers 35 exhaust outward through the two gas apertures 36 into the two buffer chambers 37. Keep pumping out the two buffer chambers 37 to pump away the vapor and the gas exhausting from the gas chambers 35 into the two buffer chambers 37 and to prevent them from accumulation in the two buffer chambers 37. While the observation is in process, the electron beam of the electron microscope 90 passes through the outer and gas apertures 38 and 36 and the view holes 33 to enable the user to observe the specimen 99 (e.g. the live cell) in side the liquid chamber 32.

In the aforementioned third embodiment, the upper and lower buffer chambers 37 are for example only but not to limit the scope of the claim the present invention. Multiple-layered upper and lower buffer chambers can also enable the same observation to be one of equivalents of the present invention and should be covered by the scope of the claim of the present invention.

Referring to FIG 9, the primary part of the present invention can alternatively be combined with the specimen holder 92 having a box 94' by that the gas chambers 35' and the buffer chambers 37' incorporate with the receiving chamber 32' formed in the box 94 of the specimen holder 92. The operation is the same as that of the third embodiment and thus more descriptions are not necessary.

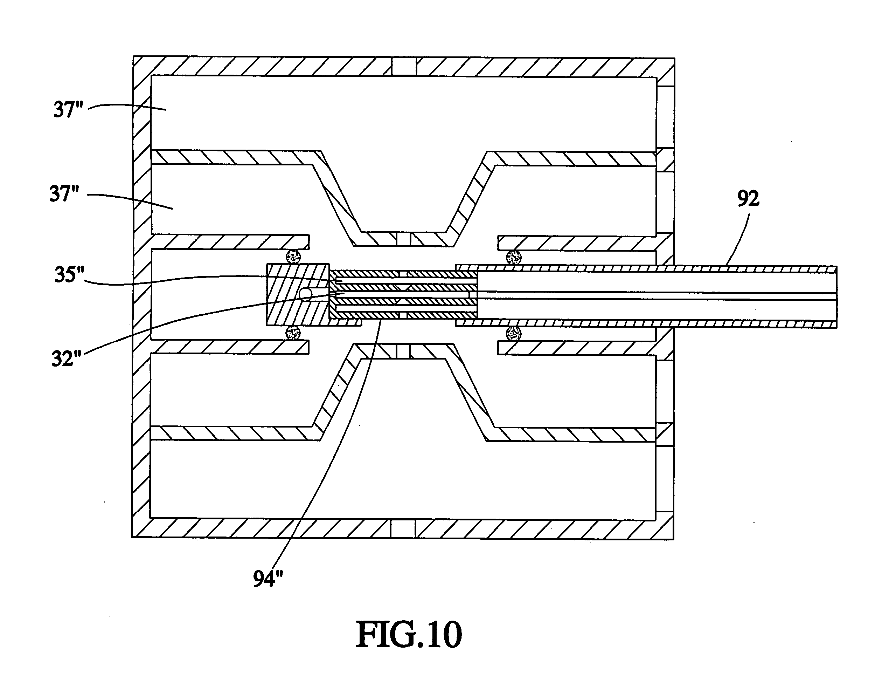

Further, FIG 10 shows the enabling status that the two buffer chambers 37" incorporate with the receiving chamber 32" formed in the box 94" of the specimen holder 92 and the gas chambers 35". The box 94" is formed in one piece and made by microlithography, such that the gas chambers 35" are ultra-thin to reduce the multiple electron scattering resulted from the electron beam impinging too many gasiform molecules when passing through the gas chamber. Further, one more buffer room is formed in the current enabling status than the third embodiment to enable the pressure of the gas inside the gas chambers 35" to be operated up to the environment of higher pressure.

Although the aforementioned three embodiments of the present invention disclose alternative locations of the film, they are for example only and not intended to limit the scope of the claim of the present invention. Taking FIG 8 in connection with the third embodiment for example, the films can be mounted to the outer apertures, or alternatively to either of the view holes and the gas apertures, or alternatively to either two of the view holes, the gas apertures, and the outer apertures to have the same bilaterally enclosing potency, other same effects, and the same operational manners as the aforementioned embodiments.

In the aforementioned embodiments, the location of the film is for example only and is not limited to adjacency to an end of one of the liquid, gas, and buffer chambers but equivalent changes and modifications may be made within the scope of the appended claims.

In addition, in the aforementioned embodiments, the liquid chamber can receive the live-cell specimen 99 which can be fixed to the internal surfaces or sidewalls of the liquid chamber or alternatively fixed to the film mounted on one of the view holes as mentioned in the first embodiment. The advantages of the prevent invention are as follows:
1. Providing an environment for the microscopic observation of the specimen or the live cell
   The present invention enables the general specimen or the live cell to be put into the liquid chamber for the observation under the electron microscope, thus overcoming the problems of the prior art which fails to observe the live cell.
2. No damage to the electron microscope
   While the liquid is injected into the liquid chamber, the film can prevent the liquid- inside the liquid chamber from escape or outward volatilization. Thus, the present invention enables the microscopic observation to be more easy and clear without damage to the electron microscope.

Although the present invention has been described with respect to specific preferred embodiments thereof, it is no way limited to the details of the illustrated structures but changes and modifications may be made within the scope of the appended claims.

## Claims

1. A closed observational device (10) for an electron microscope being **characterized in that** said closed observational device (10) comprises:
a housing (11) having a liquid chamber (12) formed therein, at least one view hole (13) formed at each of a top side thereof and a bottom side thereof and communicating with said liquid chamber (12) and coaxially aligned with the other, and a film (131) mounted to and sealing each of said view holes (13).

2. The device (10) as defined in claim 1, wherein each of said view holes (13) has a diameter of 5-500µm.

3. The device (10) as defined in claim 1, wherein each of said films (131) is located to an end of each of said view holes (13), abutting said liquid chamber (12), and the distance between said two films (131) is smaller than 10µm.

4. The device (10) as defined in claim 3, wherein each of said films (131) has a plurality of strips (132) mounted at at least one end surface thereof.

5. The device (10) as defined in claim 4, wherein said strips (132) are disposed on each of said films (131) in parallel or intersection or concentric circle or radius.

6. The device (10) as defined in claim 3, wherein each of said films (131) and said housing are formed in one piece.

7. The device (10) as defined in claim 6, wherein said strips (132) and each of said films (131) are formed in one piece.

8. The device (10) as defined in claim 1, wherein said housing (11) further comprises an inlet (111) and an outlet (112) formed at two sides of said housing (11) respectively.

9. A closed observational device (20) for an electron microscope, comprising:
a housing (21) having at least one spacer (24) for partitioning its internal space into a liquid chamber (22) and at least one gas chamber (25), at least one view hole (23) formed at each of a top side of and a bottom side of said liquid chamber (22) and located at said at least one spacer (24) and communicating with said liquid chamber (22), at least one gas aperture (26) formed at each of a top side thereof and a bottom side thereof and coaxially aligned with said view holes (23), a film (261) mounted to and sealing each of said gas apertures (26), and at least one pressure balance aperture (251) formed at a side of said gas chamber (25), wherein said at least one gas chamber (25) at least encapsulates said view holes (23).

10. The device (20) as defined in claim 9, wherein each of said films (261) is located to an end of each of said gas apertures (26), abutting said gas chamber (25).

11. The device (20) as defined in claim 9, wherein said housing (21) further comprises an inlet (211) and an outlet (212) formed at two sides of said liquid chamber (22) respectively.

12. A closed observational device (30) for an electron microscope, comprising:
a housing (31) having at least two spacers (34) for partitioning its internal space into a liquid chamber (32) formed therein, at least one gas chamber (35) formed therein, at least one buffer chamber (37) formed therein, at least one view hole (33) formed at each of a top side of and a bottom side of said liquid chamber (32) and located at one of said at least two spacers (34) and communicating with said liquid chamber (32), at least one gas aperture (36) formed at each of a top side of and a bottom side of said gas chamber (35) and located at the other spacer (34), at least one outer aperture (38) formed at each of a top side of and a bottom side of said housing (31) and located at said housing (31) and coaxially aligned with said view holes (33) and said gas apertures (36), a film (381) mounted to and sealing said outer apertures (38), at least one gas inlet (351) formed at a side of said at least one gas chamber (35), and at least one pumping port (371) formed at a side of said at least one buffer chamber (37), wherein said at least one gas chamber (35) at least encapsulates said view holes (33), and said at least one buffer chamber (37) at least encapsulates said gas apertures (36).

13. The device as (30) defined in claim 12, wherein each of said films (381) is located to an end of each of said outer apertures (38), abutting said at least one buffer chamber (37).

14. The device (30) as defined in claim 12, wherein said housing (31) further comprises an inlet (311) and an outlet (312) formed at two sides of said liquid chamber (32) respectively.
